# EUROPEAN PATENT APPLICATION

(11) **EP 4 557 908 A1**
(43) Date of publication of application: **21.05.2025**
(21) Application number: 24190796.3
(22) Date of filing: 25.07.2024
(51) Int. Cl.: H10D 30/62

(54) **AREA EFFICIENT FIN-BASED LATERALLY-DIFFUSED METAL-OXIDE SEMICONDUCTOR FIELD-EFFECT TRANSISTOR**

(30) Priority: 26.07.2023 US 202318359669
(71) Applicant: Avago Technologies International Sales Pte. Limited, Singapore 768923 (SG)
(72) Inventor: Liu, Qing, Irvine, 92602 (US)
(74) Representative: Dilg, Haeusler, Schindelmann Patentanwaltsgesellschaft mbH

(57) **Abstract**

An area-efficient LDMOS FinFET is provided. An apparatus (100, 200) includes a substrate having a first doping, the substrate comprising a first well (210) having a second doping, and a second well (215) having a third doping, and a fin (125) disposed on the substrate. The fin (125) is positioned over the first well (210) and extends, at least in part, over the second well (215). The fin (125) includes a first doped region disposed on the first well (210) and having a doping lighter than the second doping, and a second doped region disposed on the first well (210) having the third doping.

## Description

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for an area-efficient architecture for a laterally-diffused metal-oxide semiconductor (LDMOS) fin-based field-effect transistors.

### BACKGROUND

Fin-based, also referred to as fin-shaped, field-effect transistors (FinFET) have been widely adopted in complementary metal-oxide semiconductor (CMOS) technology for scalability and space savings. In the context of LDMOS, conventional substrate ties cause the device array area to increase. As advanced technology nodes continue to decrease in size, larger footprints and area correspond to increasingly higher costs.

Thus, methods, systems, and apparatuses for an area efficient LDMOS FinFET are provided.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Fig. 1 is a schematic top view of an area efficient LDMOS FinFET, in accordance with various embodiments;
Fig. 2 is a schematic diagram of a cross-section of the area efficient LDMOS FinFET, in accordance with various embodiments;
Fig. 3 is a schematic top view of one arrangement of an LDMOS FinFET array, in accordance with various embodiments; and
Fig. 4 is a plot of I-V characteristics of an area efficient LDMOS FinFET, in accordance with various embodiments.

### DETAILED DESCRIPTION OF EMBODIMENTS

Various embodiments set forth an area-efficient LDMOS FinFET.

In some embodiments, an apparatus for an area-efficient LDMOS FinFET is provided. The apparatus includes a substrate having a first doping, the substrate comprising a first well having a second doping and a second well having a third doping. The apparatus further includes a fin disposed on the substrate, a gate disposed on the fin, and a first epitaxial layer having the second doping, wherein the first epitaxial layer is disposed on a first region of the fin and at least part of the second well of the substrate. The apparatus further includes a second epitaxial layer having the third doping, wherein the second epitaxial layer is disposed on a second region of the fin and at least part of the second well of the substrate.

In further embodiments, an alternative apparatus for an area-efficient LDMOS FinFET is provided. The apparatus includes one or more fins formed of a semiconductor material and disposed on a substrate and extending in a first direction, the one or more fins comprising an undoped region, a first doped region, and a second doped region. The apparatus further includes a gate at least partially disposed on the one or more fins, the gate extending in a second direction traversing the one or more fins, and a dummy gate disposed on the one or more fins, the dummy gate extending in the second direction, wherein the dummy gate has a first side facing the gate, and a second side facing away from the gate. The first doped region may be disposed between the gate and dummy gate, wherein the first doped region has a second doping. The second doped region may be disposed on the second side of the dummy gate, wherein the wherein the second doped region has a third doping.

In further embodiments, an apparatus for an area-efficient LDMOS FinFET is provided. The apparatus includes a substrate having a first doping, the substrate comprising a first well having a second doping, and a second well having a third doping, and a fin disposed on the substrate. The fin is positioned over the first well and extends, at least in part, over the second well. The fin includes a first doped region disposed on the first well and having the second doping, and a second doped region disposed on the first well having the third doping.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

Conventional substrate ties are typically arranged to surround an LDMOS (or LDMOS array) on all sides, increasing the space taken by individual LDMOS FinFETs. The technology design rule manual (DRM) further specifies guard rings to surround LDMOS arrays, further increasing the footprint of LDMOS arrays.

In some embodiments, a proposed LDMOS substrate tie structure provides a way to reduce the footprint of individual LDMOS devices. Specifically, by providing a highly-doped epitaxial layer adjacent to the source as a substrate tie, the footprint of the LDMOS device may be reduced.

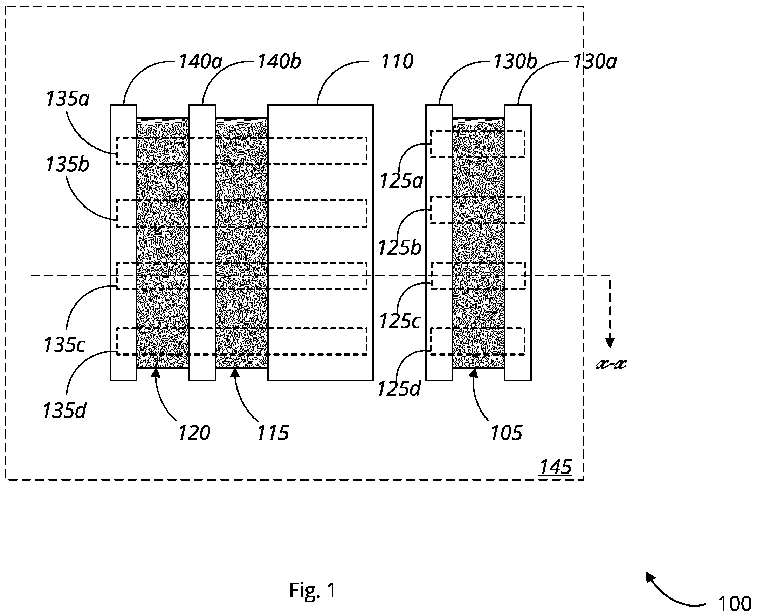

Fig. 1 is a schematic top view of an area efficient LDMOS FinFET (hereinafter FinFET 100), in accordance with various embodiments. The FinFET 100 includes a drain region 105, gate 110, source region 115, substrate tie 120, one or more first fins 125a-125d (collectively "the first set of fins 125"), first dummy gates 130a-130b, one or more second fins 135a-135d (collectively "the second set of fins 135"), second dummy gates 140a-140b, and substrate 145. It should be noted that the various parts and components of FinFET 100 are schematically illustrated in Fig. 1, and that modifications to the various components and other arrangements of FinFET 100 may be possible and in accordance with the various embodiments.

In various embodiments, the structures of the FinFET 100 may be disposed on substrate 145. Accordingly, the substrate 145 may be a semiconductor substrate, such as, without limitation, bulk silicon. In some embodiments, the substrate includes a lightly doped ("p⁻" or "n⁻") region. For example, in the case of an n-type LDMOS (NLDMOS), the substrate 145 may be lightly boron doped (e.g., p⁻). Thus, in various embodiments, the substrate 145 may have an "initial" doping (e.g., a light p-type or n-type doping), on which more heavily doped regions may be formed (e.g., a well). Thus, the substrate 145 may further include more heavily doped ("p⁺" or "n⁺") regions, respectively doped with n-type (e.g., phosphorous) and p-type dopants (e.g., boron). A well (referred to interchangeably as "well region"), accordingly, refers to a doped region formed within the substrate 145, which serves as the "bulk" or "body" of the FinFET 100, on (or in) which other parts of the device are formed, such as the drain region 105, gate 110, source region 115, substrate tie 120, the first set of fins 125, first dummy gates 130a-130b, the second set of fins 135, and second dummy gates 140a-140b. A "p-well" refers to a well with p-type doping, and an "n-well" refers to a well with n-type doping.

In the embodiments above, and further embodiments set forth below, boron and phosphorous are provided as non-limiting examples, and it is to be understood that in other embodiments, other dopants may be utilized. For example, suitable dopants may include, without limitation, pentavalent atoms (e.g., arsenic, phosphorous, antimony, bismuth, lithium, etc.) for n-type doping and trivalent atoms (e.g., indium, aluminum, gallium, boron, etc.) for p-type doping.

In various embodiments, the first set of fins 125 and the second set of fins 135 may first be disposed on the substrate 145. Fins may be formed using various processes, including, without limitation, growing and/or depositing the fins onto the substrate 145 (e.g., via an epitaxial process), forming the fins via lithography and/or etching, or a combination of processes.

The gate 110, first dummy gates 130a-130b, and second dummy gates 140a-140b may then be formed by deposition of gate oxide (e.g., a dielectric layer) over the first and second sets of fins 125, 135, followed by formation of the gate 110 and first and second dummy gates 130a-130b, 140a-140b from the gate oxide. In some examples, the gate 110 and/or first and second dummy gates 130a-130b, 140a-140b may first be patterned and then deposited onto the substrate 145 and/or the first and second sets of fins 125, 135. In yet further examples, the gate 110 may be referred to as a "gate dielectric layer," and the first and second dummy gates 130a-130b, 140a-140b may be referred to as "dummy dielectric layers." Dummy gates (or dummy dielectric layers), as used herein, refer to inactive gate structures used for various purposes. In various examples, dummy gates may be used as structural support, electrical biasing, electrical isolation, and/or as a placeholder structure to later be removed or replaced.

In various embodiments, the drain region 105 may be disposed on a first side of the gate 110. In some embodiments, the drain region 105 is disposed between the first dummy gates 130a-130b, and includes a highly doped part of the first set of fins 125. In various examples, the first set of fins 125 may include a highly doped portion that is doped in-situ to form at least part of the drain region. In some examples, in the case of an NLDMOS, all or part of the first set of fins 125 may be in-situ phosphorous doped. In some embodiments, an epitaxial layer may be formed over the fins as part, or in addition to the in-situ doping process. The epitaxial layer may refer to a structure / layer grown via an epitaxial process. In this example, the epitaxial layer may form, at least part, of a raised source / drain (RSD) structure. In some examples, the epitaxial layer may be heavily doped, and formed as part of the drain 105 (also referred to as "drain/source"). The drain region 105 may be referred to interchangeably as the "drain" or "drain/source" of the FinFET 100. In some examples, the epitaxial layer may be configured to connect the one or more first fins 125a-125d. For example, the epitaxial layer may extend longitudinally, such that the epitaxial layer traverses the one or more first fins 125a-125d, as depicted in Fig. 1.

Similarly, the source region 115 may be disposed on a second side of the gate 110 (e.g., opposite from the first side of the gate 110). For example, in some embodiments, the source region 115 is disposed between second dummy gate 140b and the gate 110. Like the drain region 105, the source region 115 may include a highly doped portion of the second set of fins 135. Specifically, the second set of fins 135 may include a first highly doped portion that is doped in-situ to form at least part of the source region. In some examples, in the case of an NLDMOS, a first portion of the second set of fins 135 may be in-situ phosphorous doped. Similarly, a respective source-side epitaxial layer may be formed over the first portion of the second set of fins 135 as part, or in addition to the in-situ doping process. The epitaxial layer may similarly be heavily doped, and form at least part of the source (also referred to as "source/drain"). The source region 115 may be referred to interchangeably as the "source" or "source/drain" of the FinFET 100. In some examples, the epitaxial layer may be configured to connect the one or more second fins 135a-135d. The epitaxial layer of the source 115 may extend in a longitudinal direction such that it traverses the one or more second fins 135a-135d, extending in a longitudinal direction, as depicted in Fig. 1.

In various embodiments, a substrate tie 120 may be disposed adjacent to the source region 115, between second dummy gate 140a and second dummy gate 140b. The substrate tie 120 may also include a highly doped portion of the second set of fins 135. Specifically, the second set of fins 135 may include a second highly doped portion that is doped in-situ to form at least part of the substrate tie 120. In the case of an NLDMOS, the second portion of the second set of fins 135 may be in-situ boron doped. In some examples, the substrate tie 120 is a structure that directly connects to the p-well, and provides a p-type connection to the substrate 145. As with the drain and source regions 105, 115, the substrate tie 120 may also include a respective epitaxial layer ("substrate tie epitaxial layer") that is formed over the second portion of the second set of fins 135 as part, or in addition to the in-situ doping process. The substrate tie epitaxial layer may similarly be doped (e.g., p-type), and formed as part of the substrate tie 120. In some examples, the substrate tie epitaxial layer may be configured to connect the one or more second fins 135a-135d across the respective second portions.

Substrate ties, such as substrate tie 120, are configured to provide a connection between the source region 115 and substrate 145. Specifically, the substrate tie 120 may be configured to be in direct contact with the p-well, but doped more lightly than the p-well. In some examples, the substrate tie 120 is doped to a level that is between that of the doping of the substrate and the doping of the p-well. In yet further examples, the substrate tie 120 may be doped to the level of the substrate. As used herein, a doping level refers to the doping concentration (e.g., concentration of dopant) in the underlying semiconducting material (e.g., the epitaxial layer, fin, and/or substrate). By providing the substrate tie 120 in close proximity to the source region 115, space savings and a reduction in minority carrier flow (e.g., parasitic effects) may be realized.

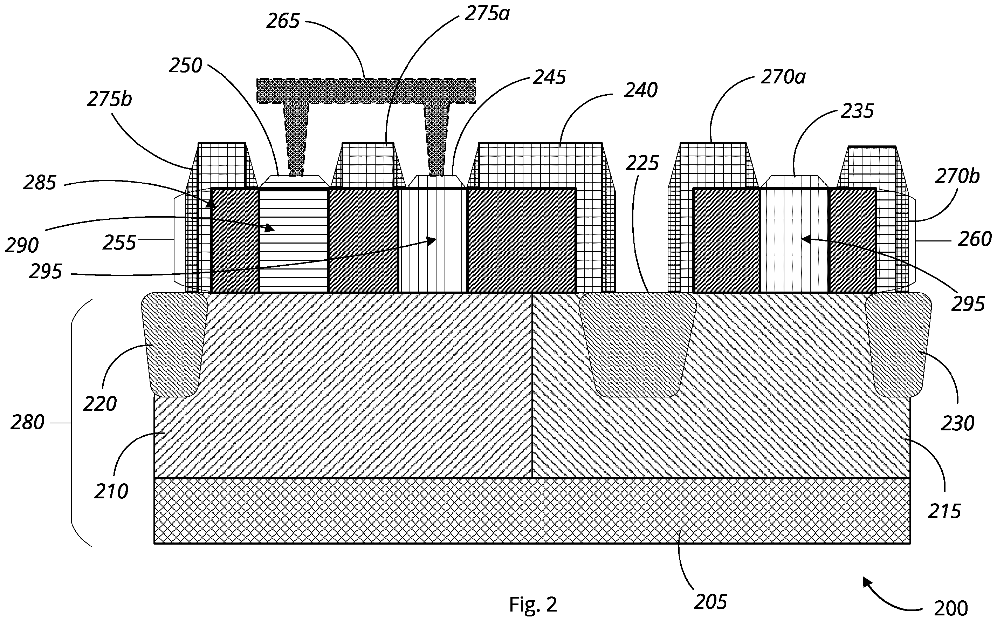

Fig. 2 is a schematic diagram of a cross-section of the FinFET 100, 200, taken across line *x-x,* in accordance with various embodiments. The sectional view of FinFET 200 shows the different portions and structures described above, but obscured in the top view. Accordingly, FinFET 200 includes a substrate 280, having an undoped/lightly doped region 205, a first well region 210, and second well region 215, a first trench isolation region 220, second trench isolation region 225, and third trench isolation region 230, drain region 235, gate 240, source region 245, substrate tie 250, first fin 260, second fin 255, bridge structure 265, first dummy gates 270a-270b, and second dummy gates 275a-275b. It should be noted that the various parts and components of FinFET 200 are schematically illustrated in Fig. 2, and that modifications to the various components and other arrangements of FinFET 200 may be possible and in accordance with the various embodiments.

As shown in the cross-sectional view, the substrate 280 may include an undoped/lightly doped region 205. In various examples, the substrate 280 may be lightly doped. In an NLDMOS, for example, the undoped/lightly doped region 205 is lightly boron doped (e.g., p-type). In various examples, the substrate 280 further includes a first well region 210 and second well region 215. In various examples, the well regions 210, 215 may be heavily doped regions of the substrate 280. For example, in an NLDMOS, the first well region 210 may be p-type doped (e.g., boron doped), and the second well region 215 may be n-type doped (e.g., phosphorous doped). In various examples, the substrate 280 further includes trench isolation regions, such as first through third trench isolation regions 220-230. Trench isolation regions may be trenches formed in the substrate, and filled with an oxide material. In some examples, one or more of the first, second, and third trench isolation regions 220-230 may be shallow trench isolation (STI) regions. In some examples, one or more of the first, second, and third trench isolation regions 220-230 may be deep trench isolation (DTI) regions.

The first and second fins 260, 255 may be disposed on the substrate 280, with the first fin 260 disposed on the second well region 215, and the second fin 255 at least partially disposed on the first well region 210, and at least partially disposed on the second well region 215. Each of the first fin 260 and second fin 255 may include both doped (depicted in lighter hatching) and undoped regions (depicted in darker hatching). For example, the undoped regions 285 of the second fin 255 may act as channels for current flow between gate and source. In some examples, the doped regions may be doped with different dopant types within the same fin. For example, a first type doped region 290, depicted in horizontal hatching, may be one of p-type or n-type doped. A second type doped region 295, depicted in vertical hatching, may be doped differently from the first type doped region 290. In one example, if the first type doped region 290 is p-type, the second type doped region 295 may be n-type. In other embodiments, the first and second type doped regions 290, 295 may be doped with the same type dopant, but doped to differing levels (e.g., light n-type doping, and heavy n-type doping). In some examples, the second fin 255 may include both a first type doped region 290 and a second type doped region 295. The first fin 260 may also include a second type doped region 295.

As previously described with respect to Fig. 1, the first type doped region 290 of the second fin 255 may form at least part of the substrate tie 250. The substrate tie 250 may further include an epitaxial layer disposed on the first type doped region 290 of the second fin 255. The second type doped region 295 of the second fin 255 may form at least part of the source region 245. The source region 245 may further include an epitaxial layer disposed on the second type doped region 295 of the second fin 255. The second type doped region 295 of the first fin 260 may form at least part of the drain region 235. The drain region 235 may similarly include an epitaxial layer disposed on the second type doped region 295 of the first fin 260.

In some further embodiments, the FinFET 200 may further include a bridge 265. The bridge 265 may be a conductive structure (e.g., a metal or other conductive material) configured to couple the source region 245 to the substrate tie 250. In various embodiments, the bridge 265 may be disposed on at least part of the source region 245. In some examples, the epitaxial layer of the source region may form at least part of a source electrode connected to one or more source regions of one or more respective fins. Thus, the bridge 265, in some examples, may be disposed on at least part of the source electrode. In some further examples, the bridge 265 may further be disposed on at least part of the substrate tie 250. In various embodiments, the bridge 265 is configured to provide a direct connection between the source region 245 and the substrate tie 250, eliminating the need for a separate guard ring and realizing additional space savings.

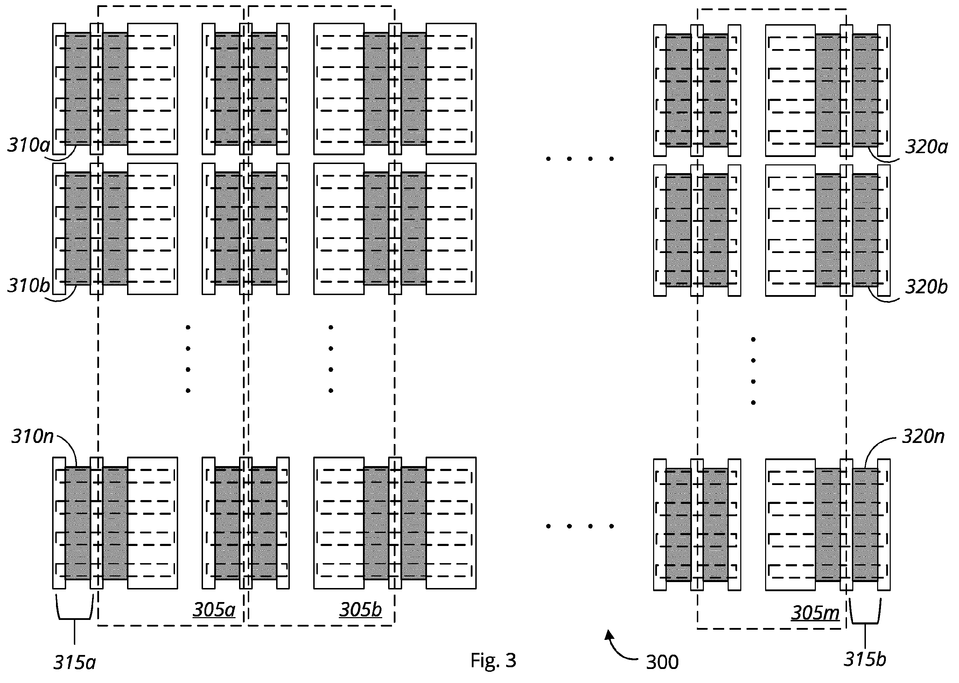

Fig. 3 is a schematic top view of a LDMOS FinFET array 300, in accordance with various embodiments. The array 300 includes one or more fingers 305a-305m of LDMOS FinFET devices as described above, with a total *m*-number of fingers where *m* is an integer. Each finger 305a-305m may respectively include a stack of an *n-*number of FinFET devices, where *n* is an integer. Spacers may be utilized to separate stacked FinFET devices within a respective finger, and further between the FinFET devices of directly adjacent fingers. Spacers, in some examples, include metal oxide and/or other dielectric spacers.

In some examples, FinFET devices of adjacent fingers may have flipped orientations (e.g., source-gate-drain for a FinFET device in a first finger, and drain-gate-source for FinFET devices in the adjacent finger). Substrate ties 310a-310n, 320a-320n may be disposed at both ends of the array (e.g., a first end 315a, and second end 315b). For example, in an NLDMOS, a p⁺ substrate tie may be provided directly at the end of an n⁺ source region side, eliminating the need for a guard ring to encompass the entire array 300.

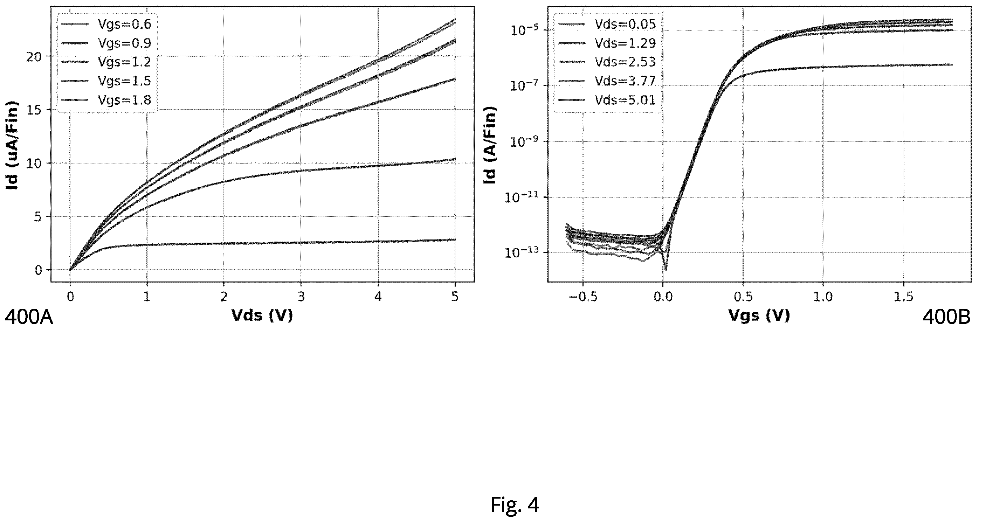

Fig. 4 illustrates two plots of I-V characteristics of an area efficient LDMOS FinFET, in accordance with various embodiments. A first plot 400A depicts the drain characteristics of an area efficient LDMOS FinFET against an LDMOS FinFET utilizing a conventional guard ring and conventional substrate tie structures, with characteristics nearly overlapping over a range of gate-to-source (V_{gs}) values. A second plot 400B depicts the I_{d}/V_{g} transfer characteristics of the area efficient LDMOS FinFET against the LDMOS FinFET utilizing a conventional guard ring and conventional substrate tie structures, in which the characteristics similarly overlap over a range of drain-to-source (V_{ds}) values.

While some features and aspects have been described with respect to the embodiments, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. An apparatus (100, 200) comprising:
a substrate (145, 280) having a first doping, the substrate (145, 280) comprising a first well (210) having a second doping and a second well (215) having a third doping;
a fin (125) disposed on the substrate (145, 280);
a gate (110, 240) disposed on the fin (125);
a first epitaxial layer having the second doping, wherein the first epitaxial layer is disposed on a first region of the fin (125) and at least part of the second well (215) of the substrate (145, 280); and
a second epitaxial layer having the third doping, wherein the second epitaxial layer is disposed on a second region of the fin (125) and at least part of the second well (215) of the substrate (145, 280).

2. The apparatus (100, 200) of claim 1, wherein the first epitaxial layer is a source electrode (115, 245), the apparatus (100, 200) further comprising:
a bridge (265) disposed on at least part of the source electrode (115, 245), the bridge (265) configured to couple the source electrode (115, 245) to the second epitaxial layer.

3. The apparatus (100, 200) of claim 1 or 2, wherein the fin (125) extends in a first direction, and the first and second epitaxial layers extend longitudinally in a second direction different from the first.

4. The apparatus (100, 200) of claim 3, further comprising one or more fins (125), the one or more fins (125) including the fin (125), wherein the first epitaxial layer and second epitaxial layer traverse each of the one or more fins (125).

5. The apparatus (100, 200) of any of claims 1 to 4, wherein the first epitaxial layer has a first side in contact with the gate (110, 240) and a second side in contact with a dummy dielectric layer, and wherein the second epitaxial layer is separated from the first epitaxial layer by the dummy dielectric layer.

6. The apparatus (100, 200) of any of claims 1 to 5, wherein the first doping and third doping are a p-type doping, and the second doping is a n-type doping.

7. The apparatus (100, 200) of any of claims 4 to 6, wherein the second epitaxial layer is boron doped.

8. The apparatus (100, 200) of any of claims 4 to 7, wherein the second epitaxial layer is phosphorous doped.

9. The apparatus (100, 200) of any of claims 1 to 8, wherein the second epitaxial layer is a substrate tie (120, 250, 310) is a p-type doping.

10. An apparatus (100, 200) comprising:
one or more fins (125) formed of a semiconductor material and disposed on a substrate (145, 280) and extending in a first direction, the one or more fins (125) comprising an undoped region, a first doped region, and a second doped region;
a gate (110, 240) at least partially disposed on the one or more fins (125), the gate (110, 240) extending in a second direction traversing the one or more fins (125);
a dummy gate (130) disposed on the one or more fins (125), the dummy gate (130) extending in the second direction, wherein the dummy gate (130) has a first side facing the gate (110, 240), and a second side facing away from the gate;
wherein the first doped region is disposed between the gate (110, 240) and dummy gate (130), wherein the first doped region has a second doping; and
wherein the second doped region is disposed on the second side of the dummy gate (130), wherein the wherein the second doped region has a third doping.

11. The apparatus (100, 200) of claim 10, further comprising a first epitaxial layer disposed on the first doped region, and a second epitaxial layer disposed on the second doped region, wherein first and second epitaxial layers are disposed on the one or more fins (125) and at least part of the substrate (145, 280).

12. The apparatus (100, 200) of claim 10 or 11, comprising at least one of the following features:
wherein the second doping is n n-type doping, wherein the third doping is a p-type doping;
wherein the second doped region is a substrate tie (120, 250, 310);
wherein second doped region is boron doped.

13. The apparatus (100, 200) of any of claims 10 to 12, further comprising:
a bridge (265) configured to couple the first doped region to the second doped region.

14. An apparatus (100, 200) comprising:
a substrate (145, 280) having a first doping, the substrate (145, 280) comprising a first well (210) having a second doping, and a second well (215) having a third doping;
a fin (125) disposed on the substrate (145, 280), wherein the fin (125) is positioned over the first well (210) and extends, at least in part, over the second well (215), wherein the fin (125) comprises:
a first doped region disposed on the first well (210) and having the second doping; and
a second doped region disposed on the first well (210) having the third doping.

15. The substrate (145, 280) of claim 14, comprising at least one of the following features:
wherein the fin (125) further includes a first epitaxial structure disposed on the first doped region, and a second epitaxial structure disposed on the second doped region;
wherein the first doping and second doping are a p-type doping, wherein the third doping is a n-type doping;
wherein first doped region is boron doped;
wherein the first doped region is a substrate tie (120, 250, 310) having a third doping, wherein the third doping is lighter than the second doping and equal to or heavier than the first doping.
